# EUROPEAN PATENT APPLICATION

(11) **EP 3 828 234 A1**
(43) Date of publication of application: **02.06.2021**
(21) Application number: 19841150.6
(22) Date of filing: 19.07.2019
(51) Int. Cl.: C08L 65/00, C08K 3/22, H01L 51/50

(54) **CHARGE-TRANSPORTING COMPOSITION**

(30) Priority: 24.07.2018 JP 2018138733
(71) Applicant: Nissan Chemical Corporation, Tokyo 103-6119 (JP)
(72) Inventor: MURAKAJI, Haruka, Funabashi-shi, Chiba 274-0052 (JP); KANNO, Yuta, Funabashi-shi, Chiba 274-0052 (JP); HIGASHI, Masayuki, Funabashi-shi, Chiba 274-0052 (JP); SHIBATA, Chika, Funabashi-shi, Chiba 274-0052 (JP)
(74) Representative: Mewburn Ellis LLP
(86) International application number: PCT/JP2019/028443
(87) International publication number: WO 2020/022211

(57) **Abstract**

Provided is a charge transporting composition that gives a charge transporting thin film having high transparency and excellent flatness. Also provided is an organic EL device that exhibits excellent characteristics.

A charge transporting thin film prepared using a composition containing a polythiophene compound, metal oxide nanoparticles, a nonionic fluorine-containing surfactant and an organic solvent has high transparency and excellent flatness, and use of the charge transporting thin film as a hole injection layer allows an organic EL device having excellent characteristics to be obtained.

## Description

### TECHNICAL FIELD

The present invention relates to a charge transporting composition.

### BACKGROUND ART

In organic electroluminescent (hereinafter, also referred to as organic EL) devices, a charge transporting thin film composed of organic compounds is used as a light-emitting layer or a charge injection layer. In particular, the hole injection layer is responsible for transferring charges between the anode and the hole transport layer or the light-emitting layer, and thus serves an important function in achieving low voltage drive and high brightness in organic EL devices.

Processes for forming the hole injection layer are broadly divided into dry processes such as vapor deposition and wet processes such as spin coating, and, of these, wet processes are better able to efficiently produce thin films over a large surface area. With the current trend toward large-screen organic EL displays, therefore, development of organic EL displays using wet processes is being aggressively pursued.

Under these circumstances, as charge transporting thin films for use in organic EL devices are required to have characteristics such as charge transportability, flatness, and transparency depending on their applications and functions, there have been reports of hole injection layers that can be formed using a wet process (see, for example, Patent Documents 1 to 6).

However, there is a constant need for improvements in wet process materials for the hole injection layer, especially improvements in the transparency and the flatness of charge transporting thin films, since high transparency contributes to improvement in light extraction efficiency and the like and flatness contributes to improvement in luminescence quality and the like.

### PRIOR ART DOCUMENTS

### Patent Documents

Patent Document 1: WO 2006/025342
Patent Document 2: WO 2008/032616
Patent Document 3: WO 2010/058777
Patent Document 4: WO 2013/042623
Patent Document 5: WO 2015/186688
Patent Document 6: WO 2016/171935

### SUMMARY

### Problems to be Solved by the Invention

It is an object of the present invention to provide a charge transporting composition that gives a charge transporting thin film having high transparency and excellent flatness.

Another object of the present invention is to provide an organic EL device exhibiting excellent characteristics.

### Means for Solving the Problems

As a result of intensive research, the present inventors have found that a charge transporting thin film prepared using a composition comprising a polythiophene compound, metal oxide nanoparticles, a nonionic fluorine-containing surfactant and an organic solvent has high transparency and excellent flatness, and use of the charge transporting thin film as a hole injection layer allows an organic EL device having excellent characteristics to be obtained, and have thus completed the present invention.

That is, the present invention provides the following inventions.
1. A charge transporting composition comprising a polythiophene compound, metal oxide nanoparticles, a nonionic fluorine-containing surfactant and an organic solvent.
2. A charge transporting composition comprising a polythiophene compound, metal oxide nanoparticles, a nonionic fluorine-containing surfactant and a solvent, the solvent consisting only of an organic solvent.
3. The charge transporting composition according to preceding item 1 or 2, wherein the nonionic fluorine-containing surfactant has a perfluoroalkenyl group-containing perfluorohydrocarbon structure and an alkylene oxide structure.
4. The charge transporting composition according to preceding item 3, wherein the perfluoroalkenyl group is a branched-chain perfluoroalkenyl group.
5. The charge transporting composition according to preceding item 3, wherein the perfluoroalkenyl group-containing perfluorohydrocarbon structure is represented by any of formulae (14) to (16). 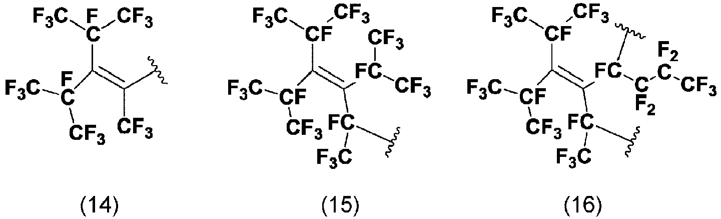
6. The charge transporting composition according to any one of preceding items 3 to 5, wherein the alkylene oxide structure comprises a group represented by - (A⁰O)ₙ -, wherein A⁰ represents an alkylene group of 2 to 10 carbon atoms and n represents an integer of 2 to 50.
7. The charge transporting composition according to any one of preceding items 1 to 6, wherein the polythiophene compound is a polythiophene derivative comprising a repeating unit represented by formula (1): 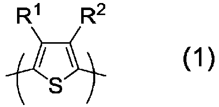 wherein R¹ and R² are, each independently, a hydrogen atom, an alkyl group of 1 to 40 carbon atoms, a fluoroalkyl group of 1 to 40 carbon atoms, an alkoxy group of 1 to 40 carbon atoms, a fluoroalkoxy group of 1 to 40 carbon atoms, an aryloxy group of 6 to 20 carbon atoms, -O-[Z-O]ₚ-R^{e}, or a sulfonic acid group; or R¹ and R² are combined to form -O-Y-O-; wherein Y is an alkylene group of 1 to 40 carbon atoms that may comprise an ether bond and may be substituted with a sulfonic acid group, Z is an alkylene group of 1 to 40 carbon atoms that may be substituted with a halogen atom, p is an integer greater than or equal to 1, R^{e} is a hydrogen atom, an alkyl group of 1 to 40 carbon atoms, a fluoroalkyl group of 1 to 40 carbon atoms, or an aryl group of 6 to 20 carbon atoms, or
   an amine adduct thereof.
8. The charge transporting composition according to any one of preceding items 1 to 7, further comprising a dopant material.
9. The charge transporting composition according to preceding item 8, wherein the dopant material is an arylsulfonic acid compound.
10. The charge transporting composition according to preceding item 8, wherein the dopant material is free of an organic compound having a molecular weight exceeding 5,000.
11. The charge transporting composition according to any one of preceding items 1 to 10, for use in the charge transporting thin film of an organic electroluminescent device having an anode, a cathode and a charge transporting thin film therebetween.
12. A charge transporting thin film obtained from the charge transporting composition according to any one of preceding items 1 to 11.
13. An organic electroluminescent device having the charge transporting thin film according to preceding item 12.
14. A method for producing a charge transporting thin film, comprising applying the charge transporting composition according to any one of preceding items 1 to 11 onto a substrate and evaporating the solvent.
15. A method for producing an organic electroluminescent device, characterized by the use of the charge transporting thin film according to preceding item 12.

### Effect of the Invention

Since the charge transporting composition of the present invention comprises metal oxide nanoparticles and a nonionic fluorine-containing surfactant as well as a polythiophene compound, use of the composition allows the formation of a thin film having high transparency and high flatness, and, moreover, although this thin film comprises a nonionic fluorine-containing surfactant, which is an insulating material, it does not adversely affect the characteristics of an organic EL device comprising the thin film.

The charge transporting composition of the present invention can therefore be suitably used for the fabrication of thin films for electronic devices, including organic EL devices, and is particularly suitable for the fabrication of the hole injection layer of an organic EL device.

In addition, the charge transporting composition of the present invention makes it possible to reproducibly produce thin films having excellent charge transportability even when using various wet processes, which are capable of forming films over a large area, such as spin-coating and ink-jet methods, and is thus able to fully accommodate recent advances in the field of organic EL devices, especially in the field of organic EL displays.

It should be noted that, in the present invention, charge transportability is synonymous with conductivity, and is synonymous with hole transportability.

### Brief Description of the Drawings

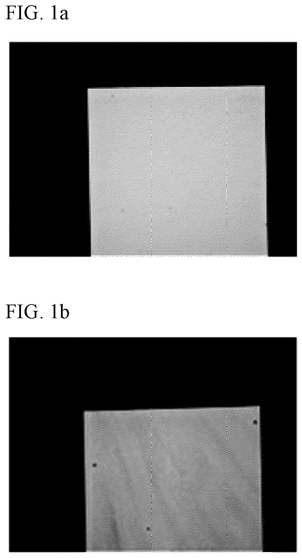

FIG. 1a is an image of light emission from the device obtained in Example 2-1.
FIG. 1b is an image of light emission from the device obtained in Comparative Example 2-1.

### Description of Embodiments

The charge transporting composition of the present invention comprises a polythiophene compound as the charge transporting material. In one preferred embodiment, from the perspective of reproducibly obtaining a charge transporting thin film that has excellent flatness and that leads to excellent lifetime characteristics when applied in an organic EL device, the polythiophene compounds contained in the charge transporting composition of the present invention do not encompass poly(3,4-ethylenedioxythiophene) (PEDOT).

In certain aspects of the present invention, from the perspective of obtaining a composition that gives a charge transporting thin film that, on applying a coating on top of it to form a functional film, can reproducibly give rise to a functional film having excellent flatness by suppressing repellence of the coating film, the polythiophene compound contained in the charge transporting composition of the present invention does not contain a fluorine atom.

The polythiophene compound contained in the charge transporting composition of the present invention comprises a plurality of structural units derived from a thiophene derivative. The weight average molecular weight thereof is usually between 1,000 and 1,000,000, but, from the perspective of inhibiting the precipitation of the polythiophene compound in the composition, preferably 500,000 or less, and more preferably 100,000 or less. The weight average molecular weight is the polystyrene equivalent value by gel permeation chromatography.

In the polythiophene compound, the structural units mentioned above that are adjacent to each other are bonded to each other, and the bonding positions are usually at the 2- and 5- positions of the thiophene ring. The plurality of structural units may be the same or different, and if two or more different structural units are contained, the structural units may be arranged in any order (random polymers, block polymers, etc.). Further, the polythiophene compound may be of the regio-random type or of the regio-regular type.

Preferably, the charge transporting composition of the present invention comprises a polythiophene derivative comprising a repeating unit represented by formula (1) or an amine adduct thereof as the charge transporting material.

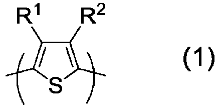

In the formula, R¹ and R² are, each independently, a hydrogen atom, an alkyl group of 1 to 20 carbon atoms, a fluoroalkyl group of 1 to 20 carbon atoms, an alkoxy group of 1 to 20 carbon atoms, a fluoroalkoxy group of 1 to 20 carbon atoms, an aryloxy group of 6 to 20 carbon atoms, -O-[Z-O]ₚ-R^{e}, or a sulfonic acid group; or R¹ and R² are combined to form -O-Y-O-; wherein Y is an alkylene group of 1 to 40 carbon atoms that may comprise an ether bond and may be substituted with a sulfonic acid group, Z is an alkylene group of 1 to 40 carbon atoms that may be substituted with a halogen atom, p is an integer greater than or equal to 1, R^{e} is a hydrogen atom, an alkyl group of 1 to 40 carbon atoms, a fluoroalkyl group of 1 to 20 carbon atoms, or an aryl group of 6 to 20 carbon atoms.

The alkyl group of 1 to 40 carbon atoms may be linear, branched chained or cyclic. Specific examples thereof include methyl, ethyl, n-propyl, isopropyl, n-butyl, isobutyl, s-butyl, t-butyl, n-pentyl, n-hexyl, n-heptyl, n-octyl, n-nonyl, n-decyl, n-undecyl, n-dodecyl, n-tridecyl, n-tetradecyl, n-pentadecylic, n-hexadecyl, n-heptadecyl, n-octadecyl, n-nonadecyl, n-eicosanyl, behenyl, triacontyl, and tetracontyl groups and the like, and alkyl groups of 1 to 18 carbon atoms are preferable, and alkyl groups of 1 to 8 carbon atoms are more preferable.

The fluoroalkyl group of 1 to 40 carbon atoms may be the alkyl group of 1 to 40 carbon atoms mentioned above in which at least one hydrogen atom is substituted with a fluorine atom, and is not particularly limited. Examples include fluoromethyl, difluoromethyl, perfluoromethyl, 1-fluoroethyl, 2-fluoroethyl, 1,2-difluoroethyl, 1,1-difluoroethyl, 2,2-difluoroethyl, 1,1,2-trifluoroethyl, 1,2,2-trifluoroethyl, 2,2,2-trifluoroethyl, 1,1,2,2-tetrafluoroethyl, 1,2,2,2-tetrafluoroethyl, perfluoroethyl, 1-fluoropropyl, 2-fluoropropyl, 3-fluoropropyl, 1,1-difluoropropyl, 1,2-difluoropropyl, 1,3-difluoropropyl, 2,2-difluoropropyl, 2,3-difluoropropyl, 3,3-difluoropropyl, 1,1,2-trifluoropropyl, 1,1,3-trifluoropropyl, 1,2,3-trifluoropropyl, 1,3,3-trifluoropropyl, 2,2,3-trifluoropropyl, 2,3,3-trifluoropropyl, 3,3,3-trifluoropropyl, 1,1,2,2-tetrafluoropropyl, 1,1,2,3-tetrafluoropropyl, 1,2,2,3-tetrafluoropropyl, 1,3,3,3-tetrafluoropropyl, 2,2,3,3-tetrafluoropropyl, 2,3,3,3-tetrafluoropropyl, 1,1,2,2,3-pentafluoropropyl, 1,2,2,3,3-pentafluoropropyl, 1,1,3,3,3-pentafluoropropyl, 1,2,3,3,3-pentafluoropropyl, 2,2,3,3,3-pentafluoropropyl, perfluoropropyl, perfluorobutyl, perfluoropentyl, perfluorohexyl, perfluoroheptyl and perfluorooctyl groups.

As for the alkoxy group of 1 to 40 carbon atoms, the alkyl group therein may be linear, branched-chained or cyclic, and examples include, but are not limited to, a methoxy group, ethoxy group, n-propoxy group, i-propoxy group, c-propoxy group, n-butoxy group, i-butoxy group, s-butoxy group, t-butoxy group, n-pentoxy group, n-hexoxy group, n-heptyloxy group, n-octyloxy group, n-nonyloxy group, n-decyloxy group, n-undecyloxy group, n-dodecyloxy group, n-tridecyloxy group, n-tetradecyloxy group, n-pentadecyloxy group, n-hexadecyloxy group, n-heptadecyloxy group, n-octadecyloxy group, n-nonadecyloxy group, and n-eicosanyloxy group.

The fluoroalkoxy group of 1 to 30 carbon atoms is not particularly limited, provided that it is an alkoxy group in which at least one hydrogen atom on a carbon atom is substituted with a fluorine atom. Examples include fluoromethoxy, difluoromethoxy, perfluoromethoxy, 1-fluoroethoxy, 2-fluoroethoxy, 1,2-difluoroethoxy, 1,1-difluoroethoxy, 2,2-difluoroethoxy, 1,1,2-trifluoroethoxy, 1,2,2-trifluoroethoxy, 2,2,2-trifluoroethoxy, 1,1,2,2-tetrafluoroethoxy, 1,2,2,2-tetrafluoroethoxy, perfluoroethoxy, 1-fluoropropoxy, 2-fluoropropoxy, 3-fluoropropoxy, 1,1-difluoropropoxy, 1,2-difluoropropoxy, 1,3-difluoropropoxy, 2,2-difluoropropoxy, 2,3-difluoropropoxy, 3,3-difluoropropoxy, 1,1,2-trifluoropropoxy, 1,1,3-trifluoropropoxy, 1,2,3-trifluoropropoxy, 1,3,3-trifluoropoxy, 2,2,3-trifluoropropoxy, 2,3,3-trifluoropropoxy, 3,3,3-trifluoropropoxy, 1,1,2,2-tetrafluoropropoxy, 1,1,2,3-tetrafluoropropoxy, 1,2,2,3-tetrafluoropropoxy, 1,3,3,3-tetrafluoropropoxy, 2,2,3,3-tetrafluoropropoxy, 2,3,3,3-tetrafluoropropoxy, 1,1,2,2,3-pentafluoropropoxy, 1,2,2,3,3-pentafluoropropoxy, 1,1,3,3,3-pentafluoropropoxy, 1,2,3,3,3-pentafluoropropoxy, 2,2,3,3,3-pentafluoropropoxy and perfluoropropoxy groups.

The alkylene group of 1 to 40 carbon atoms may be linear, branched-chained or cyclic, and examples include, but are not limited to, a methylene group, ethylene group, propylene group, trimethylene group, tetramethylene group, pentylene group, hexylene group, heptylene group, octylene group, nonylene group, decylene group, undecylene group, dodecylene group, tridecylene group, tetradecylene group, pentadecylene, hexadecylene group, heptadecylene group, octadecylene group, nonadecylene group, eicosanylene group and the like.

Examples of the aryl group of 6 to 20 carbon atoms include a phenyl group, tolyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group and the like; a phenyl group, a tolyl group and a naphthyl group are preferable.

Examples of the aryloxy group of 6 to 20 carbon atoms include, but are not limited to, a phenoxy group, an anthracenoxy group, a naphthoxy group, a phenanthrenoxy group, and a fluorenoxy group.

Examples of the halogen atom include a fluorine atom, a chlorine atom, a bromine atom, and an iodine atom.

In the polythiophene derivative comprising the repeating unit represented by formula (1) above, it is preferable that R¹ and R² are, each independently, a hydrogen atom, a fluoroalkyl group of 1 to 40 carbon atoms, an alkoxy group of 1 to 40 carbon atoms, -O[C(R^{a}R^{b})-C(R^{c}R^{d})-O]ₚ-R^{e}, -OR^{f}, or a sulfonic acid group, or that R¹ and R² are combined to form -O-Y-O-.

R^{a} to R^{d}, each independently, represent a hydrogen atom, an alkyl group of 1 to 40 carbon atoms, a fluoroalkyl group of 1 to 40 carbon atoms, or an aryl group of 6 to 20 carbon atoms, and specific examples of these groups are the same as those listed above.

Of these, it is preferable that R^{a} to R^{d} are, each independently, a hydrogen atom, an alkyl group of 1 to 8 carbon atoms, a fluoroalkyl group of 1 to 8 carbon atoms, or a phenyl group.

R^{e} is preferably a hydrogen atom, an alkyl group of 1 to 8 carbon atoms, a fluoroalkyl group of 1 to 8 carbon atoms, or a phenyl group; more preferably, a hydrogen atom, a methyl group, a propyl group, or a butyl group.

R^{f} is preferably a hydrogen atom, an alkyl group of 1 to 40 carbon atoms, a fluoroalkyl group of 1 to 40 carbon atoms, or an aryl group of 6 to 20 carbon atoms; more preferably, a hydrogen atom, an alkyl group of 1 to 8 carbon atoms, a fluoroalkyl group of 1 to 8 carbon atoms, or a phenyl group; even more preferably - CH₂CF₃.

p is preferably 1, 2, or 3.

In the present invention, R¹ is preferably a hydrogen atom or a sulfonic acid group, more preferably a sulfonic acid group, and R² is preferably an alkoxy group of 1 to 40 carbon atoms or O-[Z-O]ₚ-R^{e}, more preferably -O[C(R^{a}R^{b})-C(R^{c}R^{d})-O]ₚ-R^{e} or -OR^{f}, even more preferably -O[C(R^{a}R^{b})-C(R^{c}R^{d})-O]ₚ-R^{e}, -O-CH₂CH₂-O-CH₂CH₂-O-CH₃, -O-CH₂CH₂-O-CH₂CH₂-O, or -O-CH₂CH₂-OH; or R¹ and R² are preferably combined to form -O-Y-O-.

In a preferred embodiment of the present invention, for example, the polythiophene derivative above comprises a repeating unit in which R¹ is a sulfonic acid group and R² is other than a sulfonic acid group, or comprises a repeating unit in which R¹ and R² are combined to form -O-Y-O-.

That is, the polythiophene derivative above preferably comprises a repeating unit in which R¹ is a sulfonic acid group and R² is an alkoxy group of 1 to 40 carbon atoms or -O-[Z-O]ₚ-R^{e}, or comprises a repeating unit in which R¹ and R² are combined to form -O-Y-O-.

More preferably, the polythiophene derivative above comprises a repeating unit in which R¹ is a sulfonic acid group and R² is -O[C(R^{a}R^{b})-C(R^{c}R^{d})-O]ₚ-R^{e} or -OR^{f}.

Even more preferably, the polythiophene derivative above comprises a repeating unit in which R¹ is a sulfonic acid group and R² is -O[C(R^{a}R^{b})-C(R^{c}R^{d})-O]ₚ-R^{e}, or comprises a repeating unit in which R¹ and R² are combined to form -O-Y-O-.

Still more preferably, the polythiophene derivative above comprises a repeating unit in which R¹ is a sulfonic acid group and R² is -O-CH₂CH₂-O-CH₂CH₂-O-CH₃, -O-CH₂CH₂-O-CH₂CH₂-OH, or -O-CH₂CH₂-OH, or comprises a repeating unit in which R¹ and R² are represented by formulae (Y1) or (Y2) below.

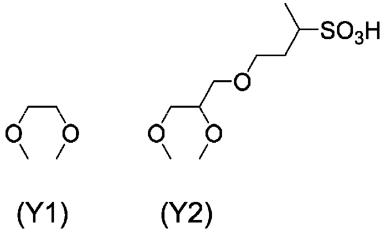

Preferable examples of the polythiophene derivative above include, but are not limited to, polythiophene derivatives comprising any one of the repeating units represented by formulae (1-1) to (1-5) below.

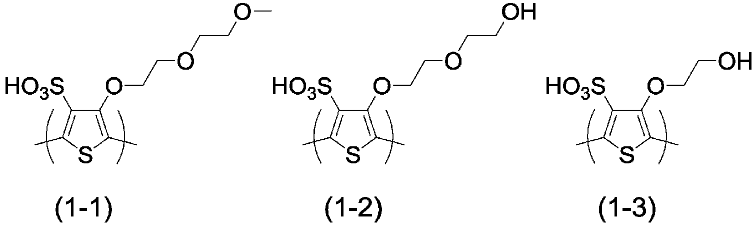

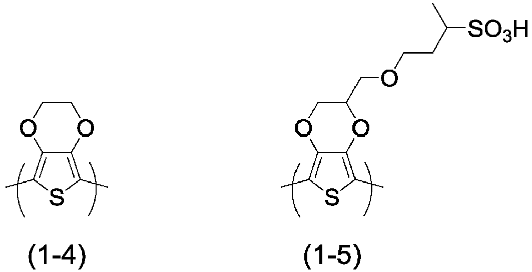

It should be noted that the polythiophene derivative above does not necessarily need to have a sulfonic acid group in all its repeating units. Accordingly, not all the repeating units necessarily have the same structure, and repeating units of different structures may be included. Examples of suitable structures thereof include, but are not limited to, a polythiophene derivative having the structure represented by formula (1a) below. In the following formula, each unit may be randomly bonded or may be bonded in the form of a block polymer.

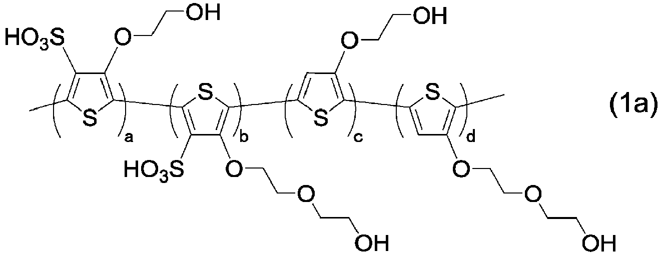

In the formula, a to d represent the ratio by mole of each unit and satisfy 0 ≤ a≤1, 0≤b≤1, 0<a+b≤1,0≤c<1, 0≤d<1, and a+b+c+d=1.

The polythiophene derivative above may be homopolymers or copolymers, including statistical, random, gradient, and block copolymers. The polythiophene derivative may comprise repeating units derived from other types of monomers such as, for example, thienothiophenes, selenophenes, pyrroles, furans, tellurophenes, anilines, arylamines, and arylenes, such as, for example, phenylenes, phenylene vinylenes, and fluorenes.

In the present invention, the polythiophene derivative comprises repeating units represented by formula (1) preferably in an amount of greater than 50 mol %, more preferably greater than 80 mol %, even more preferably greater than 90 mol %, still more preferably greater than 95 mol %, and most preferably mol 100%, relative to all the repeating units contained in the polythiophene derivative.

In the present invention, depending on the purity of the starting monomer compound(s) used in the polymerization, the polymer formed may comprise repeating units derived from impurities. In the present invention, the term "homopolymer" above is intended to mean a polymer comprising repeating units derived from one type of monomer, but it may comprise repeating units derived from impurities. In the present invention, the polythiophene derivative above is preferably a homopolymer wherein all of the repeating units are repeating units represented by formula (1), more preferably a homopolymer wherein all of the repeating units are repeating units represented by any one of formulae (1-1) to (1-5) above.

In the present invention, when the polythiophene derivative above comprises a repeating unit having a sulfonic acid group, from the perspective of further improving solubility and dispersibility in organic solvents, an amine compound may be further used to form an amine adduct in which the amine compound is added to at least some of the sulfonic acid groups in the polythiophene derivative.

Examples of amine compounds that can be used to form amine adducts include monoalkylamine compounds such as methylamine, ethylamine, n-propylamine, isopropylamine, n-butylamine, isobutylamine, s-butylamine, t-butylamine, n-pentylamine, n-hexylamine, n-heptylamine, n-octylamine, 2-ethylhexylamine, n-nonylamine, n-decylamine, n-undecylamine, n-dodecylamine, n-tridecylamine, n-tetradecylamine, n-pentadecylamine, n-hexadecylamine, n-heptadecylamine, n-octadecylamine, n-nonadecylamine and n-eicosanylamine; primary amine compounds such as monoarylamine compounds, including aniline, tolylamine, 1-naphthylamine, 2-naphthylamine, 1-anthrylamine, 2-anthrylamine, 9-anthrylamine, 1-phenanthrylamine, 2-phenanthrylamine, 3-phenanthrylamine, 4-phenanthrylamine, and 9-phenanthrylamine; dialkylamine compounds such as N-ethylmethylamine, N-methyl-n-propylamine, N-methylisopropylamine, N-methyl-n-butylamine, N-methyl-s-butylamine, N-methyl-t-butylamine, N-methylisobutylamine, diethylamine, N-ethyl-n-propylamine, N-ethylisopropylamine, N-ethyl-n-butylamine, N-ethyl-s-butylamine, N-ethyl-t-butylamine, dipropylamine, N-n-propylisopropylamine, N-n-propyl-n-butylamine, N-n-propyl-s-butylamine, diisopropylamine, N-n-butylisopropylamine, N-t-butylisopropylamine, di(n-butyl)amine, di(s-butyl)amine, diisobutylamine, aziridine (ethylene imine), 2-methylaziridine (propylene imine), 2,2-dimethylaziridine, azetidine (trimethylene imine), 2-methylazetidine, pyrrolidine, 2-methylpyrrolidine, 3-methylpyrrolidine, 2,5-dimethylpyrrolidine, piperidine, 2,6-dimethylpiperidine, 3,5-dimethylpiperidine, 2,2,6,6-tetramethylpiperidine, hexamethylene imine, heptamethylene imine, and octamethylene imine and the like; diarylamine compounds such as diphenylamine, N-phenyl-1-naphthylamine, N-phenyl-2-naphthylamine, 1,1'-dinaphthylamine, 2,2'-dinaphthylamine, 1,2'-dinaphthylamine, carbazole, 7H-benzo[c]carbazole, 11H-benzo[a]carbazole, 7H-dibenzo[c,g]carbazole, 13H-dibenzo[a,i]carbazole and the like; secondary amine compounds such as alkylarylamine compounds, including N-methylaniline, N-ethylaniline, N-n-propylaniline, N-isopropylaniline, N-n-butylaniline, N-s-butylaniline, N-isobutylaniline, N-methyl-1-naphthylamine, N-ethyl-1-naphthylamine, N-n-propyl-1-naphthylamine, indoline, isoindoline, and 1,2,3,4-tetrahydroquinoline, and 1,2,3,4-tetrahydroisoquinoline; trialkylamine compounds such as N,N-dimethylethylamine, N,N-dimethyl-n-propylamine, N,N-dimethylisopropylamine, N,N-dimethyl-n-butylamine, N,N-dimethyl-s-butylamine, N,N-dimethyl-t-butylamine, N,N-dimethylisobutylamine, N,N-diethylmethylamine, N-methyldi(n-propyl)amine, N-methyldiisopropylamine, N-methyldi(n-butyl)amine, N-methyldiisobutylamine, triethylamine, N,N-diethyl-n-butylamine, N,N-diisopropylethylamine, N,N-di(n-butyl)ethylamine, tri(n-propyl)amine, tri(i-propyl)amine, tri(n-butyl)amine, tri(i-butyl)amine, 1-methylazetidine, 1-methylpyrrolidine, and 1-methylpiperidine; triarylamine compounds such as triphenylamine; alkyldiarylamine compounds such as N-methyldiphenylamine, N-ethyldiphenylamine, 9-methylcarbazole, and 9-ethylcarbazole; and tertiary amine compounds such as dialkylarylamine compounds, including N,N-diethylaniline, N,N-di(n-propyl)aniline, and N,N-di(i-propyl)aniline, N,N-di(n-butyl)aniline; and considering the balance between properties such as the solubility of the amine adduct and the charge transportability of the resulting charge transporting thin film, triethylamine is preferable.

Amine adducts can be obtained by adding a polythiophene derivative to an amine itself or a solution thereof and stirring the mixture well.

In the present invention, the polythiophene derivative or the amine adduct thereof above may be used after treatment with a reducing agent.

In a polythiophene derivative, the chemical structure of some of the repeating units constituting it may assume an oxidized structure called a "quinoid structure." The term "quinoid structure" is used as opposed to the term "benzenoid structure"; whereas the latter is a structure comprising an aromatic ring, the former refers to a structure in which double bond(s) in the aromatic ring have moved out of the ring (as a result of which the aromatic ring disappears), thereby forming two double bonds outside the ring that are conjugated to the other double bond(s) remaining in the ring. Those skilled in the art will readily appreciate the relationship between these two structures from the relationship between the structures of benzoquinone and hydroquinone. The quinoid structures for the repeating units of various conjugated polymers are well known to those skilled in the art. As an example, the quinoid structure corresponding to the repeating unit represented by formula (1) above is shown in the following formula (1').

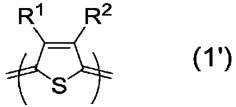

In formula (1') above, R¹ and R ² are as defined in formula (1).

This quinoid structure forms part of the structures called the "polaron structure" and the "bipolaron structure," which are generated by what is called the doping reaction, a process by which a polythiophene derivative comprising the repeating unit represented by formula (1) above is subjected to oxidation by a dopant, and which impart charge transportability to the polythiophene derivative. These structures are known in the art. The introduction of the "polaron structure" and/or the "bipolaron structure" is essential in the fabrication of an organic EL device, and in fact, this is achieved by intentionally causing the above-mentioned doping reaction to occur when the thin film formed from a charge transporting composition is baked during the fabrication of an organic EL device. The presence of the quinoid structure in a polythiophene derivative observed before the doping reaction is caused to occur is believed to be attributable to an unintended oxidation reaction that is equivalent to the doping reaction and is undergone by the polythiophene derivative in the manufacturing process thereof (in particular, the sulfonation step therein).

There is a correlation between the amount of quinoid structure contained in the polythiophene derivative above and the solubility and the dispersibility of the polythiophene derivative in an organic solvent; as the amount of quinoid structure increases, its solubility and dispersibility tend to decrease. Therefore, whereas the introduction of a quinoid structure after the formation of a thin film from the charge transporting composition does not cause such a problem, if an excess amount of quinoid structure is introduced into the polythiophene derivative by the above-mentioned unintended oxidation reaction, it may negatively affect the production of the charge transporting composition. Polythiophene derivatives are known to show variations in solubility and dispersibility in organic solvents, and it is believed that one of the reasons for this is because the amount of quinoid structure introduced into the polythiophene derivative by the unintentional oxidation reaction discussed above varies depending on the difference in the production conditions used for each polythiophene derivative.

Accordingly, subjecting the polythiophene derivative to reduction treatment using a reducing agent decreases, through reduction, the amount of quinoid structure, even if there was excessive quinoid structure introduced in the polythiophene at first. This improves the solubility and dispersibility of the polythiophene in an organic solvent, thereby allowing for stable production of a good charge transporting composition that gives a thin film having excellent homogeneity.

There are no particular restrictions on the conditions for the reduction treatment as long as they allow the quinoid structure above to be converted properly, through reduction, into a non-oxidized structure, i.e., the benzenoid structure above (e.g., in the polythiophene derivative comprising a repeating unit represented by formula (1) above, the quinoid structure represented (1') above is converted to the structure represented by formula (1) above), but this treatment can be carried out, for example, simply by contacting the polythiophene derivative or an amine adduct thereof with a reducing agent in the presence or absence of a suitable solvent.

There are no particular restrictions on the reducing agent either, as long as it can properly cause reduction, and, for example, ammonia water, hydrazine and the like, which are readily available as commercial products, are suitable.

The amount of the reducing agent cannot be specified unconditionally, as it varies according to the type of reducing agent used, but, typically, the amount of the reducing agent is 0.1 part by mass or more per 100 parts by mass of the polythiophene derivative or an amine adduct thereof to be treated, from the perspective of ensuring proper reduction, and 10 parts by mass or less per 100 parts by mass of the polythiophene derivative or an amine adduct thereof to be treated, from the perspective of preventing an excess of reducing agent from remaining.

One specific example of methods for reduction treatment is stirring a polythiophene derivative or an amine adduct thereof in 28% ammonia water overnight at room temperature. Reduction treatment under such relatively mild conditions sufficiently improves the solubility and dispersibility of the polythiophene derivative and the amine adduct thereof in organic solvents.

When an amine adduct of a polythiophene derivative is used in the charge transporting composition of the present invention, the above-mentioned reduction treatment may be performed prior to the addition of an amine compound to form the amine adduct or may be performed after the formation of the amine adduct.

A polythiophene derivative or an amine adduct thereof that was not dissolved in the solvent used for the reduction treatment at the start of the treatment may be dissolved at the completion of the treatment, as a result of a change in the solubility and dispersibility of the polythiophene derivative or the amine adduct thereof in the solvent caused by the reduction treatment. In such cases, the polythiophene derivative or the amine adduct thereof can be recovered, for example, by adding an organic solvent incompatible with the polythiophene derivative or the amine adduct thereof (such as acetone and isopropyl alcohol in the case of a sulfonated polythiophene) to the reaction system to cause precipitation of the polythiophene derivative or the amine adduct thereof before subjecting it to filtration.

The polythiophene derivative comprising the repeating unit represented by formula (1) or an amine adduct thereof has a weight average molecular weight of preferably between about 1,000 and 1,000,000, more preferably between about 5,000 and 100,000, even more preferably between about 10,000 to about 50,000. A weight average molecular weight above these lower limits allows good electrical conductivity to be obtained reproducibly, and a weight average molecular weight below these upper limits improves solubility in solvents. It should be noted that the weight average molecular weight is the polystyrene equivalent value by gel permeation chromatography.

The polythiophene derivative or an amine adduct thereof contained in the charge transporting composition of the present invention may be composed of one type of, or may be composed of two or more types of polythiophene derivatives comprising a repeating unit represented by formula (1) or amine adducts thereof.

In addition, for the polythiophene derivative comprising a repeating unit represented by formula (1), a commercially available product may be used, or those obtained through polymerization by a method known in the art using a thiophene derivative or the like as a starting material may be used, but in both cases, it is preferable to use a polythiophene derivative purified by such methods as reprecipitation or ion exchange. The use of a purified polythiophene derivative allows further enhancement of the characteristics of an organic EL device comprising a thin film obtained from a composition comprising this compound.

The sulfonation of conjugated polymers and sulfonated conjugated polymers, including sulfonated polythiophenes, are described in U.S. Patent No. 8,017,241 to Seshadri et al.

Also, sulfonated polythiophenes are described in WO 2008/073149 and WO 2016/171935.

At least part of the polythiophene derivative comprising the repeating unit represented by formula (1) or an amine adduct thereof contained in the charge transporting composition of the present invention is dissolved in an organic solvent.

Without intending to restrict the present invention to any particular forms, to the extent that the effect of the present invention is not impaired, a charge transporting material consisting of a charge transporting compound other than a polythiophene derivative comprising a repeating unit represented by formula (1) may be combined for the charge transporting material, but it is preferable to use only polythiophene derivatives comprising repeating units represented by formula (1).

The amount of charge transporting material in the charge transporting composition of the present invention is typically determined, as appropriate, in the range of 0.01 to 20 mass % of the total composition, taking into account the desired film thickness, viscosity of the composition and other factors.

The charge transporting composition of the present invention comprises metal oxide nanoparticles. A nanoparticle means a fine particle with a mean particle size for primary particles on the order of nanometers (typically 500 nm or less). The metal oxide nanoparticles mean a metal oxide formed into nanoparticles.

The primary particle size of the metal oxide nanoparticles for use in the present invention is not particularly limited as long as it is within the nano-size range, but preferably 2 to 150 nm, more preferably 3 to 100 nm, even more preferably 5 to 50 nm in consideration of reproducibly obtaining a thin film having excellent flatness. It is to be noted that the particle sizes refer to values measured using the nitrogen adsorption isotherm by the BET method.

Metals that constitute the metal oxide nanoparticles in the present invention encompass metalloids in addition to metals in the usual sense of the term.

The metals in the usual sense of the term are not particularly limited, but it is preferable to use one, or two or more selected from the group consisting of tin (Sn), titanium (Ti), aluminum (Al), zirconium (Zr), zinc (Zn), niobium (Nb), tantalum (Ta), and W (tungsten).

By contrast, a "metalloid" refers to a chemical element that has chemical and/or physical properties in between those of metals and nonmetals. Although no universal definition of metalloids has been established, in the present invention, the term "metalloid" refers to the following six elements: boron (B), silicon (Si), germanium (Ge), arsenic (As), antimony (Sb), and tellurium (Te). These metalloids may be used alone or in combination of two or more, or may be used in combination with a metal in the usual sense.

The metal oxide nanoparticles used in the present invention preferably comprise oxides of one, or two or more metals selected from boron (B), silicon (Si), germanium (Ge), arsenic (As), antimony (Sb), tellurium (Te), tin (Sn), titanium (Ti), aluminum (Al), zirconium (Zr), zinc (Zn), niobium (Nb), tantalum (Ta), and W (tungsten). It should be noted that when the metal is a combination of two or more, the metal oxide may be a mixture of oxides of individual single metals or may be a composite oxide comprising a plurality of metals.

Specific examples of metal oxides include B₂O₃, B₂O, SiO₂, SiO, GeO₂, GeO, As₂O₄, As₂O₃, As₂O₅, Sb₂O₃, Sb₂O₅, TeO₂, SnO₂, ZrO₂, Al₂O₃, ZnO and the like; B₂O₃, B₂O, SiO₂, SiO, GeO₂, GeO, As₂O₄, As₂O₃, As₂O₅, SnO₂, SnO, Sb₂O₃, TeO₂, and mixtures thereof are preferable and SiO₂ is more preferable.

For the metal oxide nanoparticles contained in the charge transporting composition of the present invention, one type may be used alone, or two or more types may be used.

The metal oxide nanoparticles contained in the charge transporting composition of the present invention are, preferably, uniformly dispersed in the composition.

The metal oxide nanoparticles may comprise one or more organic capping groups. Such organic capping groups may be reactive or non-reactive. Examples of reactive organic capping groups include organic capping groups that can be crosslinked by ultraviolet light or a radical initiator.

The amount of the metal oxide nanoparticles in the charge transporting composition of the present invention is not particularly limited, but from the perspective of, among others, inhibiting aggregation of the particles in the charge transporting composition and reproducibly obtaining a thin film having excellent flatness, the amount of the metal oxide nanoparticles is preferably 40 to 95 mass %, more preferably 50 to 95 mass %, most preferably 60 to 90 mass %, relative to the solids content

It should be noted that, in the present invention, solids means all the components other than the solvents contained in the charge transporting composition of the present invention.

In particular, in the present invention, compositions in which the metal oxide nanoparticles are uniformly dispersed can be reproducibly prepared by using a sol of metal oxide nanoparticles which is a dispersion of the metal oxide nanoparticles in a dispersion medium.

That is, a charge transporting composition in which the metal oxide nanoparticles are uniformly dispersed can be produced reproducibly by preparing a sol of metal oxide nanoparticles in advance and mixing the sol into a mixture in which a charge transporting material and the like are dissolved or dispersed in a solvent, rather than mixing the metal oxide nanoparticles themselves and a charge transporting material and the like into a solvent to form a dispersion.

For such sol of metal oxide nanoparticles, commercially available products may be used, or it may be prepared by methods known in the art using a solvent and metal oxide nanoparticles that the charge transporting composition of the present invention may comprise.

As a more specific, preferable example, in the preparation of the charge transporting composition of the present invention, it is preferable to use a silica sol in which SiO₂ nanoparticles are dispersed in a dispersion medium.

The silica sol is not particularly limited, and may be selected as appropriate from silica sols known in the art.

Commercial silica sols are typically in the form of a dispersion. Examples of commercially available silica sols include dispersions of SiO₂ nanoparticles in various solvents such as, for example, water, methanol, methyl ethyl ketone, methyl isobutyl ketone, N,N-dimethylacetamide, ethylene glycol, isopropanol, methanol, ethylene glycol monopropyl ether, cyclohexanone, ethyl acetate, toluene, dipropylene glycol monomethyl ether and propylene glycol monomethyl ether acetate.

In particular, in the present invention, a silica sol wherein the dispersion medium is a glycol-based solvent, an alcohol solvent or water is preferred.

Specific examples of commercially available silica sols include, but are not limited to, SNOWTEX (registered trademark) ST-O, ST-OS, ST-O-40, ST-OL, manufactured by Nissan Chemical Corporation, and water-dispersed silica sols such as SILICADOL 20, 30, and 40, manufactured by NIPPON CHEMICAL INDUSTRIAL CO., LTD.; and ORGANOSILICASOLs manufactured by Nissan Chemical Corporation such as methanol silica sols, MA-ST-M, MA-ST-L, IPA-ST, IPA-ST-L, IPA-ST-ZL, and EG-ST.

The concentration of SiO₂ nanoparticles in a silica sol is typically 5 to 50 % by mass. In preparing a composition, however, heed should be paid to the following: if the concentration of SiO₂ nanoparticles is high, SiO₂ nanoparticles may aggregate when the silica sol is mixed with a mixture in which a charge transporting material and the like are dissolved or dispersed in a solvent, depending on the type of solvent contained in the mixture.

The charge transporting composition of the present invention comprises a nonionic fluorine-containing surfactant. The inclusion of the nonionic fluorine-containing surfactant allows the surface of the composition upon application to be smooth (herein also referred to as the "leveling effect").

In certain embodiments of the present invention, the nonionic fluorine-containing surfactant has a perfluoroalkenyl group-containing perfluorohydrocarbon structure and an alkylene oxide structure. The perfluoroalkenyl group-containing perfluorohydrocarbon structure is not particularly limited and may be linear or branched. However, in the present invention, a structure comprising a branched chain is preferred, and a structure comprising a branched-chain perfluoroalkenyl group is more preferred.

The number of carbons thereon is not particularly limited, but the number of carbons is preferably about 2 to 20, more preferably 5 to 20, and even more preferably 5 to 15.

Examples of preferable perfluoroalkenyl group-containing perfluorohydrocarbon structures include, but are not limited to, the α-perfluorononenyl structure represented by formula (14) and the structures represented by formulas (15) and (16).

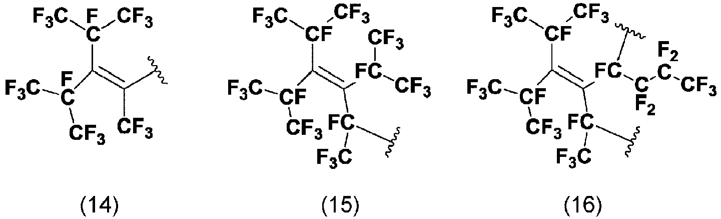

The alkylene oxide structure is not particularly limited, but an alkylene oxide structure that comprises a group represented by the formula -(A⁰O)ₙ- (wherein A⁰ is an alkylene group of 2 to 10 carbon atoms, and n is an integer from 2 to 50) is preferred, and a structure comprising an ethylene oxide group represented by the formula -(CH₂CH₂O)ₙ- (wherein n is as defined above) is more preferred.

Examples of alkylene groups of 2 to 10 carbon atoms include ethylene, propylene, trimethylene, tetramethylene, pentamethylene, hexamethylene, heptamethylene, octamethylene, nonamethylene and decamethylene groups. Alkylene groups of 2 to 4 carbon atoms are preferable.

The alkylene oxide chain may be partly branched, and the alkylene chain thereof may comprise a carbonyl group thereon.

If R_{f} denotes the perfluoroalkenyl group-containing perfluorohydrocarbon structure, nonionic fluorine-containing surfactants that can be suitably used in the present invention are exemplified by, but not limited to, those represented by formula (A1) or (A2) for the structures represented by formulas (14) and (15), and those represented by formula (A3) for the structure of formula (16).

Rf-O-(A⁰O)n-R⁰ (A1)

R_{f}-O-(A⁰O)n-R_{f} (A2)

R⁰-(OA⁰)ₙ-O-R_{f}-O-(A⁰O)ₙ-R⁰ (A3)

wherein each R_{f} is independently a perfluoroalkenyl group-containing perfluorohydrocarbon structure, each R⁰ is independently a hydrogen atom or an alkyl group of 1 to 20 carbon atoms, and A⁰ and n are as defined above

The alkyl groups of 1 to 20 carbon atoms may be linear, branched or cyclic, and illustrative examples include linear or branched alkyl groups of 1 to 20 carbon atoms, such as methyl, ethyl, n-propyl, isopropyl, n-butyl, isobutyl, s-butyl, t-butyl, n-pentyl, n-hexyl, n-heptyl, n-octyl, n-nonyl and n-decyl groups; and cyclic alkyl groups of 3 to 20 carbon atoms such as cyclopropyl, cyclobutyl, cyclopentyl, cyclohexyl, cycloheptyl, cyclooctyl, cyclononyl, cyclodecyl, bicyclobutyl, bicyclopentyl, bicyclohexyl, bicycloheptyl, bicyclooctyl, bicyclononyl and bicyclodecyl groups.

More preferably, R_{f}-O- is an α-perfluorononenyloxy structure represented by formula (14') and A⁰ is an ethylene group. Specific examples thereof include α-perfluorononenyloxy-co-methylpolyethylene oxide and α-perfluorononenyloxy-ω-perfluorononenylpolyethylene oxide.

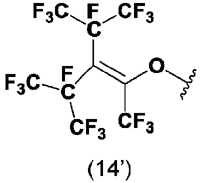

Nonionic fluorine-containing surfactants that may be used in this invention can be synthesized by the methods described in, for example, JP-A 2010-47680, JP-A 2011-57589 or JP-A 2012-72287, or may be acquired as commercial products.

Examples of commercial products include nonionic fluorine-containing surfactants from Neos Co., Ltd. such as the Ftergent M series (251, 212M, 215M, 250 (a-perfluorononenyloxy-co-methylpolyethylene oxide)), the F series (209F, 222F, 245F), the G series (208G, 218GL, 240G), the P and D series (212P, 220P, 228P, FTX-218, DFX-18), and the oligomer series (710FL, 710FM, 710FS, 730FL, 730LM). Of these, the M series, the F series, the G series, the P and D series (212P, 220P, 228P) and the oligomer series (710FL, 710FM, 710FS) are preferred.

In the present invention, for the nonionic fluorine-containing surfactant, one type may be used alone or two or more types may be used in combination.

The amount of nonionic fluorine-containing surfactant is not particularly limited, provided the desired leveling effect is achieved and the characteristics of the resulting thin film observed when used in an organic EL device are not adversely affected, but, typically, the amount is preferably from about 0.1 to about 10 mass %, more preferably from 1 to 8 mass %, and even more preferably from 3 to 7 mass % relative to the solids content.

The charge transporting composition of the present invention comprises an organic solvent.

Such organic solvents are not particularly limited as long as they dissolve or disperse each component well, and may be selected from, for example, aromatic or halogenated aromatic hydrocarbon solvents such as benzene, toluene, xylene, ethylbenzene, and chlorobenzene; aliphatic hydrocarbons such as n-heptane, n-hexane, and cyclohexane; ether-based solvents such as diethyl ether, tetrahydrofuran, dioxane, and 1,2-dimethoxyethane; ketone-based solvents such as acetone, methyl ethyl ketone, methyl isobutyl ketone and cyclohexanone; ester-based solvents such as ethyl acetate, normal hexyl acetate, ethyl lactate, and y-butyrolactone; halogenated hydrocarbon solvents such as methylene chloride, dichloromethane, 1,2-dichloroethane, and chloroform; amide-based solvents such as N,N-dimethylformamide, N,N-dimethylacetamide, N-methyl-2-pyrrolidone, and 1,3-dimethyl-2-imidazolidinone; alcohol-based solvents such as methanol, ethanol, isopropanol, n-propanol, cyclohexanol, diacetone alcohol, and 2-benzoxyethanol; Glycol ether-based solvents such as ethylene glycol monoethyl ether, ethylene glycol monobutyl ether, ethylene glycol diglycidyl ether, propylene glycol monomethyl ether, diethylene glycol monomethyl ether, diethylene glycol monoethyl ether, diethylene glycol diethyl ether, diethylene glycol dimethyl ether, triethylene glycol dimethyl ether, diethylene glycol monoethyl ether acetate, diethylene glycol monobutyl ether acetate, dipropylene glycol monomethyl ether, and propylene glycol monomethyl ether acetate; glycol-based solvents such as ethylene glycol, propylene glycol, hexylene glycol 1,3-octylene glycol, diethylene glycol, dipropylene glycol, triethylene glycol, tripropylene glycol, 1,3-butanediol, 2,3-butanediol, and 1,4-butanediol.

It should be noted that these organic solvents can be used alone or in combination of two or more types.

The charge transporting composition of the present invention may comprise water as a solvent, but from the perspective of the storage stability of the composition, jetting stability during inkjet application of the composition, and reproducibility in obtaining organic EL devices having excellent initial characteristics or durability, the water content is preferably 10 mass % or less, more preferably 5 mass % or less, relative to the total solvent content, and it is most preferable to use only organic solvents for the solvent. In this context, the term "only organic solvents" means that only organic solvents are used for the solvent, and it should not be construed as excluding the presence, in trace amounts, of water contained in the organic solvent used, solids used, or the like.

The charge transporting composition of the present invention, depending on the intended use for the resulting thin film, may comprise a dopant material for such purposes as increasing the charge transportability of the thin film.

The dopant material is not particularly limited, provided it dissolves in at least one of the solvents used in the composition, and use may be made of either an inorganic dopant material or an organic dopant material. Preferably, the dopant material is an electron accepting dopant material. The electron accepting dopant material is a material capable of imparting charge transportability to the polythiophene derivative through the doping reaction, described above, with the polythiophene derivative.

Examples of inorganic dopant materials include heteropoly acids such as phosphomolybdic acid, silicomolybdic acid, phosphotungstic acid, phosphotungstomolybdic acid and silicotungstic acid; strong inorganic acids such as hydrogen chloride, sulfuric acid, nitric acid and phosphoric acid; metal halides such as aluminum(III) chloride (AlCl₃), titanium(IV) tetrachloride (TiCl₄), boron tribromide (BBr₃), a boron trifluoride-ether complex (BF₃·OEt₂), iron(III) chloride (FeCl₃), copper(II) chloride (CuCl₂), antimony(V) pentachloride (SbCls), arsenic(V) pentafluoride (AsFs) and phosphorus pentafluoride (PFs); and halogens such as Cl₂, Br₂, I₂, IC1, ICl₃, IBr and IF₄.

Examples of organic dopant materials include tetracyanoquinodimethanes such as 7,7,8,8-tetracyanoquinodimethane (TCNQ), 2-fluoro-7,7,8,8-tetracyanoquinodimethane and 2,5-difluoro-7,7,8,8-tetracyanoquinodimethane; halotetracyanoquinodimethanes (halo-TCNQs) such as tetrafluoro-7,7,8,8-tetracyanoquinodimethane (F4TCNQ), tetrachloro-7,7,8,8-tetracyanoquinodimethane, 2-fluoro-7,7,8,8-tetracyanoquinodimethane, 2-chloro-7,7,8,8-tetracyanoquinodimethane, 2,5-difluoro-7,7,8,8-tetracyanoquinodimethane and 2,5-dichloro-7,7,8,8-tetracyanoquinodimethane; benzoquinone derivatives such as tetrachloro-1,4-benzoquinone (chloranil) and 2,3-dichloro-5,6-dicyano-1,4-benzoquinone (DDQ); arylsulfonic acid compounds such as benzenesulfonic acid, tosylic acid, p-styrenesulfonic acid, 2-naphthalenesulfonic acid, 4-hydroxybenzenesulfonic acid, 5-sulfosalicylic acid, p-dodecylbenzenesulfonic acid, dihexylbenzenesulfonic acid, 2,5-dihexylbenzenesulfonic acid, dibutylnaphthalenesulfonic acid, 6,7-dibutyl-2-naphthalenesulfonic acid, dodecylnaphthalenesulfonic acid, 3-dodecyl-2-naphthalenesulfonic acid, hexylnaphthalenesulfonic acid, 4-hexyl-1-naphthalenesulfonic acid, octylnaphthalenesulfonic acid, 2-octyl-1-naphthalenesulfonic acid, hexylnaphthalenesulfonic acid, 7-hexyl-1-naphthalenesulfonic acid, 6-hexyl-2-naphthalenesulfonic acid, dinonylnaphthalenesulfonic acid, 2,7-dinonyl-4-naphthalenesulfonic acid, dinonylnaphthalenedisulfonic acid, 2,7-dinonyl-4,5-naphthalenedisulfonic acid, the 1,4-benzodioxanedisulfonic acid derivatives described in International Publication WO 2005/000832, the arylsulfonic acid derivatives described in International Publiction WO 2006/025342 and the dinonylnaphthalenesulfonic acid derivatives described in JP-A 2005-108828; and nonaromatic sulfone compounds such as 10-camphorsulfonic acid.

These inorganic and organic dopant materials may be used alone or in combination of two or more types.

In one preferred embodiment, the arylsulfonic acids contained in the charge transporting composition of the present invention do not encompass polystyrene sulfonic acid (PSS), from the perspective of reproducibly obtaining a charge transporting thin film that has excellent flatness and provides excellent lifetime characteristics when applied to an organic EL device.

Examples of arylsulfonic acid compounds preferable as a dopant material in the present invention include the arylsulfonic acid compounds represented by formula (H1) or (H2).

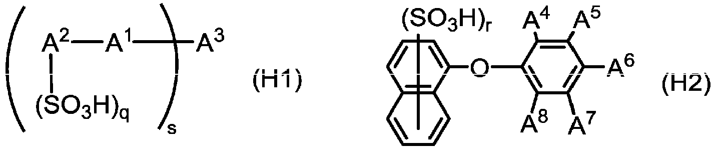

In the formulas above, A¹ represents O or S, with O being preferred.

A² represents a naphthalene ring or an anthracene ring, with a naphthalene ring being preferred.

A³ is a perfluorobiphenyl group having a valence of 2 to 4. s represents the number of bonds between A¹ and A³, and is an integer that satisfies 2 ≤ s ≤ 4. Preferably, A³ is a perfluorobiphenyldiyl group, preferably a perfluorobiphenyl-4,4'-diyl group and s is 2.

q represents the number of sulfonic acid groups that are bonded with A², and is an integer that satisfies 1 ≤ q ≤4, and is most preferably 2.

A⁴ to A⁸ are, each independently, a hydrogen atom, a halogen atom, a cyano group, an alkyl group of 1 to 20 carbon atoms, a halogenated alkyl group of 1 to 20 carbon atoms or a halogenated alkenyl group of 2 to 20 carbon atoms, with at least three from among A⁴ to A⁸ being halogen atoms.

Examples of the halogenated alkyl group of 1 to 20 carbon atoms include trifluoromethyl, 2,2,2-trifluoroethyl, 1,1,2,2,2-pentafluoroethyl, 3,3,3-trifluoropropyl, 2,2,3,3,3-pentafluoropropyl, 1,1,2,2,3,3,3-heptafluoropropyl, 4,4,4-trifluorobutyl, 3,3,4,4,4-pentafluorobutyl, 2,2,3,3,4,4,4-heptafluorobutyl and 1,1,2,2,3,3,4,4,4-nonafluorobutyl groups.

Examples of the halogenated alkenyl group of 2 to 20 carbon atoms include perfluorovinyl, perfluoropropenyl (allyl) and perfluorobutenyl groups.

The halogen atom and the alkyl group of 1 to 20 carbon atoms are exemplified in the same way as above, with the halogen atom preferably being a fluorine atom.

Of these, A⁴ to A⁸ are preferably hydrogen atoms, halogen atoms, cyano groups, alkyl groups of 1 to 10 carbon atoms, halogenated alkyl groups of 1 to 10 carbon atoms, or halogenated alkenyl groups of 2 to 10 carbon atoms, with at least 3 from among A⁴ to A⁸ being fluorine atoms; more preferably hydrogen atoms, fluorine atoms, cyano groups, alkyl groups of 1 to 5 carbon atoms, fluorinated alkyl groups of 1 to 5 carbon atoms, or fluorinated alkenyl groups of 2 to 5 carbon atoms, with at least 3 from among A⁴ to A⁸ being fluorine atoms; and even more preferably hydrogen atoms, fluorine atoms, cyano groups, perfluoroalkyl groups of 1 to 5 carbon atoms, or perfluoroalkenyl groups of 1 to 5 carbon atoms, with A⁴, A⁵ and A⁸ being fluorine atoms.

Here, a "perfluoroalkyl group" is an alkyl group in which all the hydrogen atoms are substituted with fluorine atoms, and a "perfluoroalkenyl group" is an alkenyl group in which all the hydrogen atoms are substituted with fluorine atoms.

r represents the number of sulfonic acid groups bonded to the naphthalene ring and is an integer that satisfies 1 ≤ r ≤ 4, preferably from 2 to 4, and most preferably 2.

In certain aspects of the present invention, from such perspectives as reproducibly obtaining a composition having excellent homogeneity that gives a thin film having high flatness and obtaining a composition having excellent storage stability in which solids precipitation is suppressed, the dopant material contained in the charge transporting composition of the present invention is free of organic compounds with a molecular weight exceeding 5,000, preferably organic compounds with a molecular weight exceeding 4,000, more preferably organic compounds with a molecular weight exceeding 3,000, and even more preferably organic compounds with a molecular weight exceeding 2,000.

The molecular weight of the arylsulfonic acid compound used as a dopant material is not particularly limited. However, taking into account the solubility in organic solvents observed when used together with the polythiophene compound of the present invention, the molecular weight is preferably 2,000 or less, and more preferably 1,500 or less.

Examples of arylsulfonic acid compounds that can be suitably used in the present invention include, but are not limited to, the following compounds.

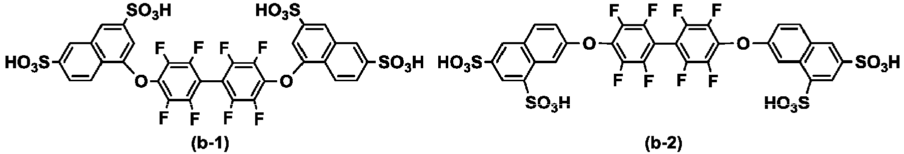

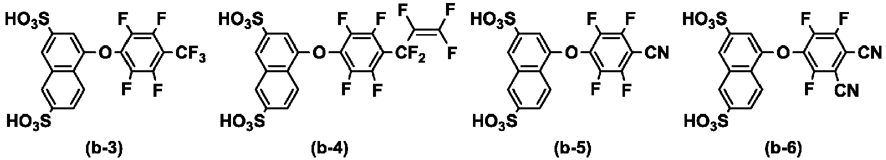

The charge transporting composition of the present invention may comprise an amine compound for such purposes as improving the dispersibility and solubility of the polythiophene compound.

Such amine compounds are not particularly limited as long as they are soluble in at least one of the solvents used in the composition, and may be one type alone or may be two or more types.

The amine compound may be a primary, secondary or tertiary amine compound.

Specific examples of primary amine compounds include monoalkylamine compounds such as methylamine, ethylamine, n-propylamine, isopropylamine, n-butylamine, isobutylamine, s-butylamine, t-butylamine, n-pentylamine, n-hexylamine, n-heptylamine, n-octylamine, 2-ethylhexylamine, n-nonylamine, n-decylamine, n-undecylamine, n-dodecylamine, n-tridecylamine, n-tetradecylamine, n-pentadecylamine, n-hexadecylamine, n-heptadecylamine, n-octadecylamine, n-nonadecylamine and n-eicosanylamine; monoarylamine compounds such as aniline, tolylamine, 1-naphthylamine, 2-naphthylamine, 1-anthrylamine, 2-anthrylamine, 9-anthrylamine, 1-phenanthrylamine, 2-phenanthrylamine, 3-phenanthrylamine, 4-phenanthrylamine, and 9-phenanthrylamine; and the like.

Specific examples of secondary amine compounds include dialkylamine compounds such as N-ethylmethylamine, N-methyl-n-propylamine, N-methylisopropylamine, N-methyl-n-butylamine, N-methyl-s-butylamine, N-methyl-t-butylamine, N-methylisobutylamine, diethylamine, N-ethyl-n-propylamine, N-ethylisopropylamine, N-ethyl-n-butylamine, N-ethyl-s-butylamine, N-ethyl-t-butylamine, dipropylamine, N-n-propylisopropylamine, N-n-propyl-n-butylamine, N-n-propyl-s-butylamine, diisopropylamine, N-n-butylisopropylamine, N-t-butylisopropylamine, di(n-butyl)amine, di(s-butyl)amine, diisobutylamine, aziridine (ethylene imine), 2-methylaziridine (propylene imine), 2,2-dimethylaziridine, azetidine (trimethylene imine), 2-methylazetidine, pyrrolidine, 2-methylpyrrolidine, 3-methylpyrrolidine, 2,5-dimethylpyrrolidine, piperidine, 2,6-dimethylpiperidine, 3,5-dimethylpiperidine, 2,2,6,6-tetramethylpiperidine, hexamethylene imine, heptamethylene imine, and octamethylene imine and the like; diarylamine compounds such as diphenylamine, N-phenyl-1-naphthylamine, N-phenyl-2-naphthylamine, 1,1'-dinaphthylamine, 2,2'-dinaphthylamine, 1,2'-dinaphthylamine, carbazole, 7H-benzo[c]carbazole, 11H-benzo[a]carbazole, 7H-dibenzo[c,g]carbazole, 13H-dibenzo[a,i]carbazole and the like; alkylarylamine compounds such as N-methylaniline, N-ethylaniline, N-n-propylaniline, N-isopropylaniline, N-n-butylaniline, N-s-butylaniline, N-isobutylaniline, N-methyl-1-naphthylamine, N-ethyl-1-naphthylamine, N-n-propyl-1-naphthylamine, indoline, isoindoline, and 1,2,3,4-tetrahydroquinoline, and 1,2,3,4-tetrahydroisoquinoline; and the like.

Specific examples of tertiary amine compounds include trialkylamine compounds such as N,N-dimethylethylamine, N,N-dimethyl-n-propylamine, N,N-dimethylisopropylamine, N,N-dimethyl-n-butylamine, N,N-dimethyl-s-butylamine, N,N-dimethyl-t-butylamine, N,N-dimethylisobutylamine, N,N-diethylmethylamine, N-methyldi(n-propyl)amine, N-methyldiisopropylamine, N-methyldi(n-butyl)amine, N-methyldiisobutylamine, triethylamine, N,N-diethyl-n-butylamine, N,N-diisopropylethylamine, N,N-di(n-butyl)ethylamine, tri(n-propyl)amine, tri(i-propyl)amine, tri(n-butyl)amine, tri(i-butyl)amine, 1-methylazetidine, 1-methylpyrrolidine, and 1-methylpiperidine; triarylamine compounds such as triphenylamine; alkyldiarylamine compounds such as N-methyldiphenylamine, N-ethyldiphenylamine, 9-methylcarbazole, and 9-ethylcarbazole; dialkylarylamine compounds such as N,N-diethylaniline, N,N-di(n-propyl)aniline, and N,N-di(i-propyl)aniline, N,N-di(n-butyl)aniline; and the like.

In particular, when the charge transporting composition of the present invention comprises an amine compound, the amine compound preferably comprises a primary amine compound, and preferably comprises a monoalkylamine, especially a monoalkylamine of 2 to 20 carbons, in view of their excellent ability to improve the dispersibility and solubility of the polythiophene compound used in the present invention.

When the charge transporting composition of the present invention comprises an amine compound, the amount of the amine compound is typically 200 mass % or less relative to the polythiophene compound, and for the purpose of achieving the effect of the amine compound described above, the amount of the amine compound is preferably 50 mass % or more.

The viscosity of the charge transporting composition of the present invention is typically 1 to 50 mPa·s at 25 °C, and its surface tension is typically 20 to 50 mN/m at 25 °C.

The viscosity and surface tension of the charge transporting composition of the present invention can be adjusted by changing the types of organic solvents used, their ratios, the concentration of the solids and the like, in consideration of various factors such as the method of application to be used and the desired film thickness.

The solids content of the charge transporting composition in the present invention should, as appropriate, be determined in consideration of the viscosity, the surface tension and other characteristics of the composition and the thickness and other characteristics of the thin film to be made, but it is typically about 0.1 to 15.0 mass %, and from the perspective of inhibiting the aggregation of the charge transporting material and the metal oxide nanoparticles in the composition, the solids content is preferably 10.0 mass % or less, more preferably about 8.0 mass % or less and even more preferably 5 mass % or less.

The charge transporting composition of the present invention can be produced, for example, by mixing a polythiophene derivative comprising a repeating unit represented by formula (1), metal oxide nanoparticles, a nonionic fluorine-containing surfactant, and an organic solvent.

The order of mixing is not particularly limited, but examples of methods that allow easy and reproducible production of the charge transporting composition of the present invention include a method involving mixing a polythiophene derivative comprising a repeating unit represented by formula (1), a nonionic fluorine-containing surfactant, and the like with an organic solvent to obtain a mixture, and then adding to the mixture a pre-prepared sol of metal oxide nanoparticles, and a method involving adding this mixture to a pre-prepared sol of metal oxide nanoparticles. In this case, if necessary, an additional organic solvent may be added at the end or some of the components that are relatively soluble in the solvent may be left out of the mixture and then added at the end. From the perspective of suppressing the aggregation and separation of components and reproducibly preparing a charge transporting composition having excellent uniformity, it is preferable to prepare a well-dispersed sol of metal oxide nanoparticles separately from the mixture comprising the other components, and then mix the two together, followed by thorough stirring. It should be noted that the metal oxide nanoparticles and the polythiophene derivative may aggregate or precipitate when mixed together, depending on the types and amounts of solvents mixed. It should also be noted that when a composition is prepared using a sol, the concentration of the sol and the amount of the sol to be used should be determined so that the resulting composition comprises the desired amount of metal oxide nanoparticles.

The composition may be heated as appropriate during its preparation as long as the ingredients do not decompose or degenerate.

In the present invention, the charge transporting composition may be filtered using a sub-micrometer filter or the like as an intermediate step during the preparation of the composition or after having mixed all the components, in order to obtain a thin film having greater flatness reproducibly.

The charge transporting thin film of the present invention can be formed on a substrate by applying the charge transporting composition described above onto the substrate and evaporating it by such means as baking.

Examples of methods for applying the composition include, but are not particularly limited to, dipping, spin coating, transfer printing, roll coating, brush coating, inkjet printing, spraying, slit coating and the like. Preferably, the viscosity and surface tension of the composition are adjusted in accordance with the method of application to be used.

When using the composition of the present invention, the baking atmosphere is not particularly limited. A thin film having a uniform film surface can be obtained not only in an open-air atmosphere, but even in an inert gas such as nitrogen or in a vacuum, but an open-air atmosphere is preferable because it allows a thin film having high charge transportability to be obtained with good reproducibility.

The baking temperature is set, as appropriate, within a range of about 100 to 260 °C, taking into account such factors as the intended use of the resulting thin film, and the level of charge transportability to be imparted to the thin film. When the resulting thin film is to be used as the hole injection layer in an organic EL device, the baking temperature is preferably about 140 to 250 °C, and more preferably about 145 to 240 °C. During baking, two- or more-step changes in temperature may be applied for such purposes as achieving more uniform film formability. Heating may be performed using a suitable apparatus such as a hot plate or an oven.

The thickness of the charge transporting thin film is not particularly limited, but when the thin film is to be used as the hole injection layer in an organic EL device, a film thickness of 5 to 200 nm is preferred. Methods for changing the film thickness include, for example, changing the solids concentration in the composition and changing the amount of solution on the substrate during application.

The charge transporting thin film of the present invention can be formed on a substrate by applying the charge transporting composition of the present invention to the substrate and evaporating it by such means as vacuum drying (drying under reduced pressure).

The organic EL device of the present invention has a pair of electrodes and has, between these electrodes, the above-described charge transporting thin film of the present invention.

Typical configurations of organic EL devices include, but are not limited to, configurations (a) to (f) below. In these configurations, where necessary, an electron blocking layer or the like may be provided between the light-emitting layer and the anode, and a hole blocking layer or the like may be provided between the light-emitting layer and the cathode. Alternatively, the hole injection layer, the hole transport layer or the hole injection and transport layer may also have the function of an electron blocking layer or the like; and the electron injection layer, the electron transport layer or the electron injection and transport layer may also have the function of a hole blocking layer or the like. In addition, any functional layer may be provided in between each layer as needed.
(a) anode / hole injection layer / hole transport layer / light-emitting layer / electron transport layer / electron injection layer / cathode
(b) anode / hole injection layer / hole transport layer / light-emitting layer / electron injection and transport layer / cathode
(c) anode / hole injection and transport layer / light-emitting layer / electron transport layer / electron injection layer / cathode
(d) anode / hole injection and transport layer / light-emitting layer / electron injection and transport layer / cathode
(e) anode / hole injection layer / hole transport layer / light-emitting layer / cathode
(f) anode / hole injection and transport layer / light-emitting layer / cathode

As used herein, "hole injection layer," "hole transport layer" and "hole injection and transport layer" refer to layers that are formed between the light-emitting layer and the anode and that have the function of transporting holes from the anode to the light-emitting layer. When only one layer of a hole transporting material is provided between the light-emitting layer and the anode, it is a "hole injection and transport layer"; when two or more layers of hole transporting materials are provided between the light-emitting layer and the anode, the layer that is closer to the anode is a "hole injection layer" and the other layer is a "hole transport layer." In particular, for the hole injection (transporting) layer, a thin film having not only an excellent ability to accept holes from the anode but also an excellent ability to inject holes into the hole transport (light-emitting) layer may be used.

As used herein, "electron injection layer," "electron transport layer" and "electron injection and transport layer" refer to layers that are formed between the light-emitting layer and the cathode and that have the function of transporting electrons from the cathode to the light-emitting layer. When only one layer of an electron transporting material is provided between the light-emitting layer and the cathode, it is an "electron injection and transport layer"; when two or more layers of electron transporting materials are provided between the light-emitting layer and the cathode, the layer that is closer to the cathode is an "electron injection layer" and the other layer is an "electron transport layer."

The "light-emitting layer" is an organic layer having a light emitting function. When a doping system is used, this layer comprises a host material and a dopant material. In this case, the function of the host material is primarily to promote the recombination of electrons and holes and to confine the resulting excitons to the inside of the light-emitting layer, and the function of the dopant material is to cause the excitons obtained by recombination to emit light efficiently. In the case of phosphorescent devices, the host material functions primarily to confine the excitons generated by the dopant to the inside of the light-emitting layer.

The charge transporting thin film of the present invention can be used in an organic EL device as a functional layer between the anode and the cathode, preferably between the anode and the light-emitting layer, such as a hole injection layer, a hole transport layer, a hole injection and transport layer, and the like, and is suitable for the hole injection layer.

The materials and methods employed to produce an organic EL device using the charge transporting composition of the present invention are exemplified by, but not limited to, those described below.

An example of a method for fabricating an OLED device having a hole transport layer comprising a thin film obtained from the charge transporting composition of the present invention is given below. It should be noted that it is preferable to treat the electrodes in advance by cleaning them with an alcohol, pure water, or the like, or subjecting them to surface treatment such as UV ozone treatment, and oxygen-plasma treatment to the extent that the electrodes are not adversely affected.

A hole injection layer comprising the charge transporting thin film of the present invention is formed on an anode substrate using the method described above. After it is introduced into a vacuum deposition system, a hole transport layer, a light-emitting layer, an electron transport layer, an electron transport layer/hole blocking layer, and a cathode metal are sequentially deposited. Alternatively, in this method, instead of forming the hole transport layer and the light-emitting layer by vapor deposition, these layers are formed by a wet process using a composition for forming the hole transport layer comprising a hole transporting polymer and a composition for forming the light-emitting layer comprising a light-emitting polymer. If necessary, an electron blocking layer may be provided between the light-emitting layer and the hole transport layer.

Illustrative examples of anode materials include transparent electrodes such as indium-tin oxide (ITO) and indium-zinc oxide (IZO), and metal anodes made of aluminum or other metals or an alloy of such metals. An anode material on which planarizing treatment has been carried out is preferred. Use can also be made of polythiophene derivatives and polyaniline derivatives that have high charge transportability.

Examples of other metals that may make up the metal anode include, but are not limited to, gold, silver, copper, indium, and alloys thereof.

The materials that form the light-emitting layer include, but are not limited to, low molecular weight light-emitting materials such as metal complexes such as an aluminum complex of 8-hydroxyquinoline, metal complexes of 10-hydroxybenzo[h]quinoline, bisstyrylbenzene derivatives, bisstyryl arylene derivatives, metal complexes of (2-hydroxyphenyl)benzothiazole, silole derivatives and the like; and systems in which a light-emitting material and an electron transport material are mixed together with a polymer compound such as poly(p-phenylene vinylene), poly[2-methoxy-5-(2-ethylhexyloxy)-1,4-phenylene vinylene], poly(3-alkylthiophene), polyvinylcarbazole and the like.

If the light-emitting layer is formed by vapor deposition, the layer may be co-deposited with a light-emitting dopant, and examples of light-emitting dopants include, but are not limited to, metal complexes such as tris(2-phenylpyridine) iridium (III) (Ir(ppy)₃), naphthacene derivatives such as rubrene, quinacridone derivatives, fused polycyclic aromatic rings such as perylene, and the like.

Examples of materials for forming the electron transport layer / hole blocking layer include, but are not limited to, oxadiazole derivatives, triazole derivatives, phenanthroline derivatives, phenylquinoxaline derivatives, benzimidazole derivatives, pyrimidine derivatives and the like.

Examples of materials for forming the electron injection layer include, but are not limited to, metal oxides such as lithium oxide (Li₂O), magnesium oxide (MgO), alumina (Al₂O₃), and metal fluorides such as lithium fluoride (LiF) and sodium fluoride (NaF).

Examples of cathode materials include, but are not limited to, aluminum, a magnesium-silver alloy, and an aluminum-lithium alloy.

Examples of materials used to form the electron blocking layer include, but are not limited to, tris(phenylpyrazole)iridium.

Examples of hole transporting polymers include poly[(9,9-dihexylfluorenyl-2,7-diyl)-co-(N,N'-bis{p-butylphenyl}-1,4-diaminophenylene)], poly[(9,9-dioctylfluorenyl-2,7-diyl)-co-(N,N'-bis{p-butylphenyl}-1,r-biphenylene-4,4-diamine)], poly[(9,9-bis{ l'-penten-5'-yl}fluorenyl-2,7-diyl)-co-(N,N'-bis{p-butylphenyl}-1,4-diaminophenylene)], poly[N,N'-bis(4-butylphenyl)-N,N'-bis(phenyl)-benzidine] end-capped with polysilsesquioxane and poly[(9,9-dioctylfluorenyl-2,7-diyl)-co-(4,4'-(N-(p-butylphenyl))diphenylamine)].

Examples of light-emitting polymers include polyfluorene derivatives such as poly(9,9-dialkylfluorene) (PDAF), poly(phenylene vinylene) derivatives such as poly(2-methoxy-5-(2'-ethylhexoxy)-1,4-phenylene vinylene) (MEH-PPV), polythiophene derivatives such as poly(3-alkylthiophene) (PAT), and polyvinylcarbazole (PVCz).

The charge transporting thin film obtained from the charge transporting composition of the present invention is, as described above, suitably used as functional layers in an organic EL device, but, in addition, it can also be used as a charge transporting thin film for use in electronic devices such as an organic photoelectric conversion device, an organic thin-film solar cell, an organic perovskite photoelectric conversion device, an organic integrated circuit, an organic field effect transistor, an organic thin film transistor, an organic light emitting transistor, an organic optical inspection device, an organic photoreceptor, an organic field quench device, a light emitting electrochemical cell, a quantum dot light emitting diode, a quantum laser, an organic laser diode and an organic plasmon light emitting device.

### Examples

### [1] Synthesis of a polythiophene derivative in which an amine is added to sulfonic acid groups

### Production Example 1

500 g of an aqueous dispersion (0.6 mass % concentration) of a polymer comprising a repeating unit represented by formula (1a) above, which is a polythiophene derivative, was mixed with 0.9 g of triethylamine, and the resulting mixture was dried and solidified by rotary evaporation. The resulting dry matter was further dried at 50 °C overnight in a vacuum oven to obtain 4 g of polythiophene derivative X, in which an amine is added to sulfonic acid groups.

### [2] Preparation of charge transporting compositions

### Example 1-1

0.032 g of polythiophene derivative X, obtained in Production Example 1, was combined into a mixed solvent of 0.73 g of ethylene glycol (Kanto Chemical Co., Ltd.), 1.93 g of diethylene glycol (Kanto Chemical Co., Ltd.), 0.047 g of n-butylamine (Tokyo Chemical Industry Co., Ltd.), 4.83 g of triethylene glycol dimethyl ether (Tokyo Chemical Industry Co., Ltd.) and 0.97 g of 2-(benzyloxy)ethanol (Kanto Chemical Co., Ltd.), and the resulting mixture was stirred at 80 °C for 2 hours (350 rpm), and then returned to room temperature.

Added to this were 0.32 g of a 10% solution of the arylsulfonic acid compound represented by formula (b-1) above in ethylene glycol, which had been prepared in advance, and 1.16 g of ORGANOSILICASOL EG-ST (Nissan Chemical Corporation, concentration: 20.5 mass %, the same applies below), in which the dispersing medium (metal oxide nanoparticles in the form of SiO₂ are dispersed therein) is ethylene glycol, and the resulting mixture was stirred at 30 °C for 30 minutes (350 rpm).

Finally, 0.015 g of Ftergent (registered trademark) 215M (Neo Company Limited) was added as a nonionic fluorine-containing surfactant, and the resulting mixture was stirred at 30 °C for 30 minutes and filtered through a PP syringe filter with a pore size of 0.2 µm to obtain 3 wt% charge transporting composition A.

The arylsulfonic acid compound represented by formula (b-1) above was synthesized according to the method described in International Publication WO 2006/025342.

### Comparative Example 1-1

Charge transporting composition B was obtained in the same manner as in Examples 1-1, except that 215M was not added.

### Comparative Examples 1-2

Charge transporting composition C was obtained in the same manner as in Examples 1-1, except that EG-ST was not added.

### [3] Fabrication and characterization of organic EL devices

### Example 2-1

Charge transporting composition A was applied to an ITO substrate using a spin coater, and was subsequently dried at 60 °C under air atmosphere for 5 minutes, and heated and baked at 230 °C for 15 minutes to form a thin film, 50 nm thick, on the ITO substrate. For the ITO substrate, a glass substrate (25 mm × 25 mm × 0.7 t) on the surface of which indium tin oxide (ITO) was patterned to a thickness of 150 nm was used, and the impurities on the surface of the glass substrate were removed by an O₂ plasma cleaning device (150 W, 30 seconds) prior to use.

Next, α-NPD (N,N'-di(1-naphthyl)-N,N'-diphenylbenzidine) was deposited using an vacuum evaporator (degree of vacuum: 1.0×10⁻⁵ Pa) to a thickness of 30 nm at a rate of 0.2 nm/sec on the ITO substrate on which the thin film was formed. Next, another film of HTEB-01 (an electron blocking material manufactured by Kanto Chemical Co., Ltd.) was formed having a thickness of 10 nm. Then, NS60 (a host material for the light emitting layer manufactured by Nippon Steel & Sumikin Chemical Co., Ltd.) and Ir(PPy)₃ (a dopant material for the light emitting layer) were co-deposited. In this co-deposition process, the deposition rate was controlled so that the concentration of Ir(PPy)₃ was 6%, and the layer was deposited to a thickness of 40 nm. Next, films of Alq₃, lithium fluoride and aluminum were successively laminated to obtain an organic electroluminescent device. In these steps, the deposition rates were set to 0.2 nm/sec for Alq₃, 0.2 nm/sec for aluminum, and 0.02 nm/sec for lithium fluoride and the film thicknesses were set to 20 nm, 0.5 nm, and 80 nm, respectively.

In order to prevent deterioration in characteristics under the influence of oxygen, water, and the like in the air, the organic EL device was sealed using sealing substrates before the characteristics thereof were evaluated. Sealing was performed by the following procedure. The organic EL device was placed between sealing substrates in a nitrogen atmosphere having an oxygen concentration of 2 ppm or less and a dew point of-76 °C or less, and the sealing substrates were bonded to each other using an adhesive (Moresco Moisture Cut WB90US (P), manufactured by MORESCO Corporation). In this step, a water-trapping agent (HD-071010W-40, manufactured by Dynic Corporation) was placed between the sealing substrates together with the organic EL device, and the sealing substrates stuck together were irradiated with UV light (wavelength: 365 nm, irradiation level: 6,000 mJ/cm²), and then annealed at 80 °C for 1 hour to cure the adhesive.

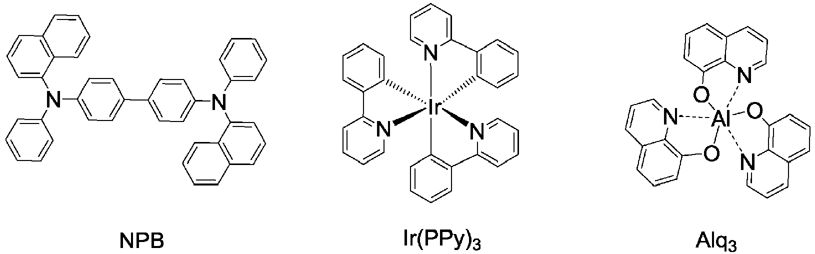

### Comparative Example 2-1

An organic EL device was fabricated in the same manner as in Example 2-1, except that charge transporting composition B was used instead of charge transporting composition A.

The devices obtained were driven at a luminance of 1000 cd/m², and the drive voltage, current density, current efficiency, and external quantum efficiency were measured. The results are shown in Table 1. Also, images of the light emission observed when the devices obtained were driven at 4.5 V are shown in FIG. 1a and FIG. 1b.

**Table 1**

| | Drive voltage (V) | Current density (mA/cm²) | Current efficiency (cd/A) | External quantum efficiency (%) |
|---|---|---|---|---|
| Example 2-1 | 4.6 | 1.8 | 56.8 | 16.3 |
| Comparative Example 2-1 | 4.8 | 1.7 | 57.7 | 16.6 |

As shown in FIG. 1a and FIG. 1b, no unevenness of emission was observed for the organic EL device comprising the charge transporting thin film of the present invention (Example 2-1), whereas the emission was observed to be uneven for the organic EL device comprising the charge transporting thin film of a comparative example (Comparative Example 2-1).

Also, as shown in Table 1, the organic EL device comprising the charge transporting thin film of the present invention (Example 2-1) showed good device characteristics despite the inclusion of a nonionic fluorine-containing surfactant in the thin film.

### Example 3-1 and Comparative Example 3-1

Charge transporting composition A was applied to a quartz substrate using a spin coater, dried at 60 °C for 5 minutes in air and then at 120 °C for 1 minute, and then baked at 230 °C for 30 minutes in a nitrogen atmosphere to obtain a thin film (film thickness: 56 nm) on the quartz substrate.

Also, a thin film (film thickness: 56 nm) was obtained on a quartz substrate by the same method, except that charge transporting composition C was used instead of charge transporting composition A.

The average transmittance of these thin films in the visible light region (wavelength: 400 nm to 800 nm) were as follows: 99.0% for the thin film obtained from charge transporting composition A, and, contrastingly, 87.4% for the thin film obtained from charge transporting composition C.

Thus, the charge transporting thin film of the present invention comprising metal oxide nanoparticles showed superior transparency compared to the thin film that did not comprise them.

## Claims

1. A charge transporting composition comprising a polythiophene compound, metal oxide nanoparticles, a nonionic fluorine-containing surfactant and an organic solvent.

2. A charge transporting composition comprising a polythiophene compound, metal oxide nanoparticles, a nonionic fluorine-containing surfactant and a solvent, the solvent consisting only of an organic solvent.

3. The charge transporting composition according to claim 1 or 2, wherein the nonionic fluorine-containing surfactant has a perfluoroalkenyl group-containing perfluorohydrocarbon structure and an alkylene oxide structure.

4. The charge transporting composition according to claim 3, wherein the perfluoroalkenyl group is a branched-chain perfluoroalkenyl group.

5. The charge transporting composition according to claim 3, wherein the perfluoroalkenyl group-containing perfluorohydrocarbon structure is represented by any of formulae (14) to (16).

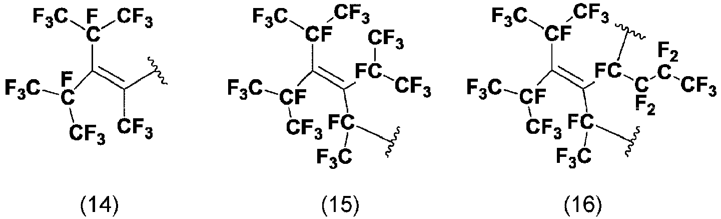

6. The charge transporting composition according to any one of claims 3 to 5, wherein the alkylene oxide structure comprises a group represented by - (A⁰O)ₙ -, wherein A⁰ represents an alkylene group of 2 to 10 carbon atoms and n represents an integer of 2 to 50.

7. The charge transporting composition according to any one of claims 1 to 6, wherein the polythiophene compound is a polythiophene derivative comprising a repeating unit represented by formula (1): 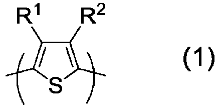 wherein R¹ and R² are, each independently, a hydrogen atom, an alkyl group of 1 to 40 carbon atoms, a fluoroalkyl group of 1 to 40 carbon atoms, an alkoxy group of 1 to 40 carbon atoms, a fluoroalkoxy group of 1 to 40 carbon atoms, an aryloxy group of 6 to 20 carbon atoms, -O-[Z-O]ₚ-R^{e}, or a sulfonic acid group; or R¹ and R² are combined to form -O-Y-O-; wherein Y is an alkylene group of 1 to 40 carbon atoms that may comprise an ether bond and may be substituted with a sulfonic acid group, Z is an alkylene group of 1 to 40 carbon atoms that may be substituted with a halogen atom, p is an integer greater than or equal to 1, R^{e} is a hydrogen atom, an alkyl group of 1 to 40 carbon atoms, a fluoroalkyl group of 1 to 40 carbon atoms, or an aryl group of 6 to 20 carbon atoms, or
an amine adduct thereof.

8. The charge transporting composition according to any one of claims 1 to 7, further comprising a dopant material.

9. The charge transporting composition according to claim 8, wherein the dopant material is an arylsulfonic acid compound.

10. The charge transporting composition according to claim 8, wherein the dopant material is free of an organic compound having a molecular weight exceeding 5,000.

11. The charge transporting composition according to any one of claims 1 to 10, for use in the charge transporting thin film of an organic electroluminescent device having an anode, a cathode and a charge transporting thin film therebetween.

12. A charge transporting thin film obtained from the charge transporting composition according to any one of claims 1 to 11.

13. An organic electroluminescent device having the charge transporting thin film according to claim 12.

14. A method for producing a charge transporting thin film, comprising applying the charge transporting composition according to any one of claims 1 to 11 onto a substrate and evaporating the solvent.

15. A method for producing an organic electroluminescent device, **characterized by** the use of the charge transporting thin film according to claim 12.
